# EUROPEAN PATENT APPLICATION

(11) **EP 4 517 923 A1**
(43) Date of publication of application: **05.03.2025**
(21) Application number: 23796395.4
(22) Date of filing: 25.04.2023
(51) Int. Cl.: H01M 10/48, H02J 7/02, H02J 50/10

(54) **BATTERY MANAGEMENT SYSTEM**

(30) Priority: 27.04.2022 US 202263335435 P
(71) Applicant: Nuvoton Technology Corporation Japan, Nagaokakyo City, Kyoto 617-8520 (JP)
(72) Inventor: YOSHIKAWA, Susumu, Nagaokakyo City, Kyoto 617-8520 (JP); KOBAYASHI, Hitoshi, Nagaokakyo City, Kyoto 617-8520 (JP); FUJII, Keiichi, Nagaokakyo City, Kyoto 617-8520 (JP); KAWABE, Akira, Nagaokakyo City, Kyoto 617-8520 (JP)
(74) Representative: Novagraaf International SA
(86) International application number: PCT/JP2023/016342
(87) International publication number: WO 2023/210655

(57) **Abstract**

A BMS (1) for managing a battery assembly includes: a BMU (201) that manages the battery assembly; and a plurality of CMUs (101, etc.) that monitor the battery assembly. One CMU (101) among the plurality of CMUs (101, etc.) includes a wireless communication circuit (111) and a timer circuit, and based on a timing at which the timer circuit times out, repeatedly transitions between a first state in which the wireless communication circuit (111) is supplied with power and therefore capable of receiving a wake-up signal transmitted by the BMU (201), and a second state in which the wireless communication circuit (111) is not supplied with power.

## Description

### [Technical Field]

The present disclosure relates to a battery management system for managing a battery assembly.

### [Background Art]

There is a battery management system that manages a battery assembly including a plurality of battery cells. The battery management system includes a plurality of monitoring circuits that monitor the current or voltage of the battery cells, and a management circuit that manages the battery assembly using the plurality of monitoring circuits (for example, see Patent Literature (PTL) 1).

### [Citation List]

### [Patent Literature]

[PTL 1] U.S. Patent No. 11,524,588

### [Summary of Invention]

### [Technical Problem]

In the battery management system, there is a problem that a relatively large amount of power is required to operate the management circuit or the monitoring circuit.

The present disclosure has an object to overcome such a problem and provide a battery management system and the like that contributes to reducing power consumption required for processing for managing a battery assembly.

### [Solution to Problem]

A battery management system according to the present disclosure is for managing a battery assembly, and includes: a management circuit that manages the battery assembly; and a plurality of monitoring circuits that monitor the battery assembly. One monitoring circuit among the plurality of monitoring circuits includes: a wireless communication circuit; and a timer circuit. Based on a timing at which the timer circuit times out, the one monitoring circuit repeatedly transitions between a first state in which the wireless communication circuit is supplied with power and therefore capable of receiving a wake-up signal transmitted by the management circuit, and a second state in which the wireless communication circuit is not supplied with power.

General or specific aspects of the present disclosure may be realized as a system, a method, an integrated circuit, a computer program, a computer-readable recording medium such as CD-ROM, or any given combination thereof.

### [Advantageous Effects of Invention]

According to the present disclosure, the battery management system contributes to reducing power consumption required for processing for managing the battery assembly.

### [Brief Description of Drawings]

[FIG. 1]

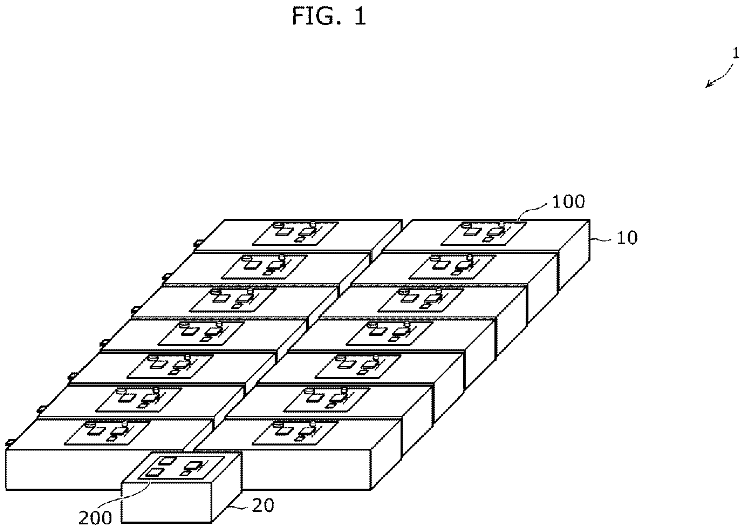

   FIG. 1 is an external view illustrating one example of a battery management system according to Embodiment 1.
[FIG. 2]

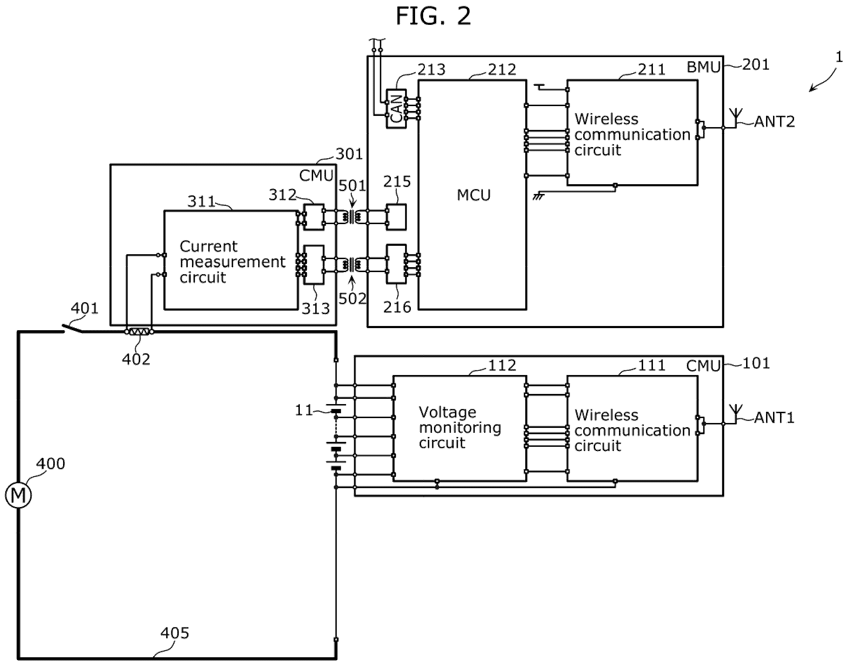

   FIG. 2 is a configuration diagram illustrating one example of a battery management system according to Embodiment 1.
[FIG. 3]

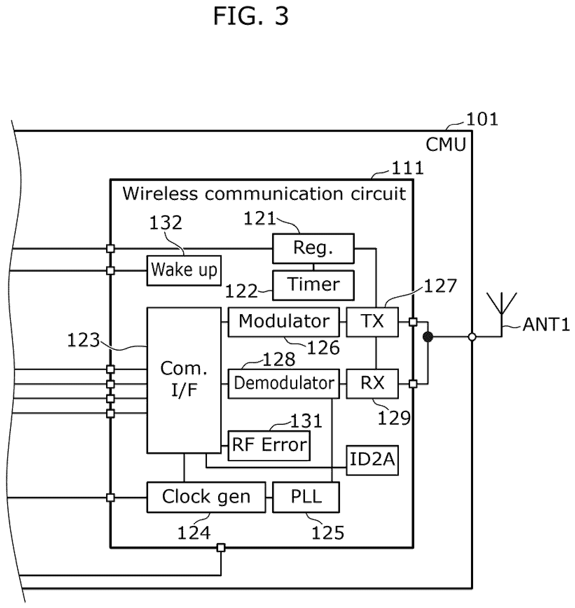

   FIG. 3 is a configuration diagram illustrating one example of a wireless communication circuit included in a cell monitoring circuit according to Embodiment 1.
[FIG. 4]

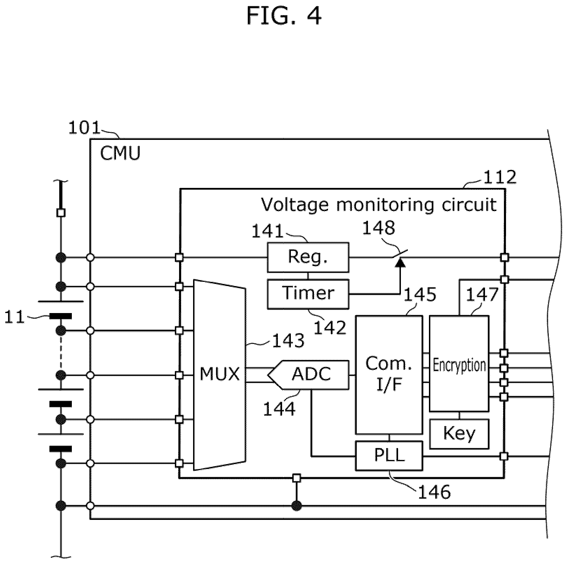

   FIG. 4 is a configuration diagram illustrating one example of a voltage monitoring circuit included in a cell monitoring circuit according to Embodiment 1.
[FIG. 5]

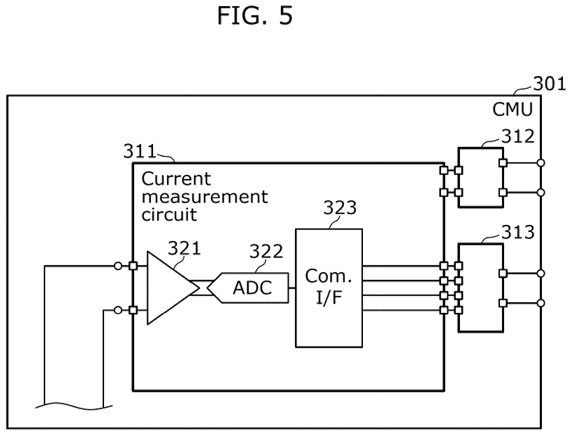

   FIG. 5 is a configuration diagram illustrating one example of a current measurement circuit included in a current monitoring circuit according to Embodiment 1.
[FIG. 6]

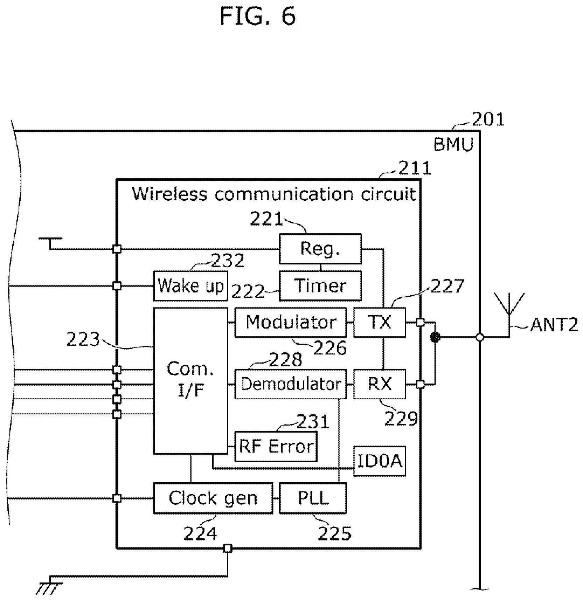

   FIG. 6 is a configuration diagram illustrating one example of a wireless communication circuit included in a management circuit according to Embodiment 1.
[FIG. 7]

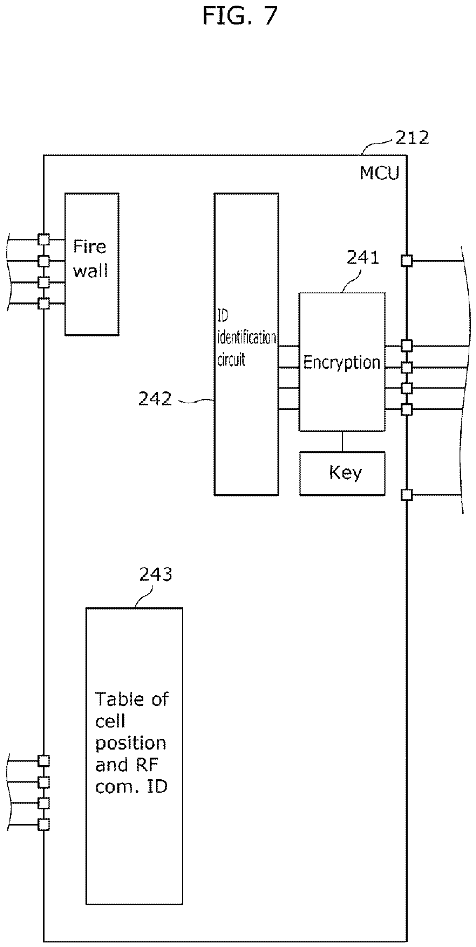

   FIG. 7 is a configuration diagram illustrating one example of an MCU included in a management circuit according to Embodiment 1.
[FIG. 8]

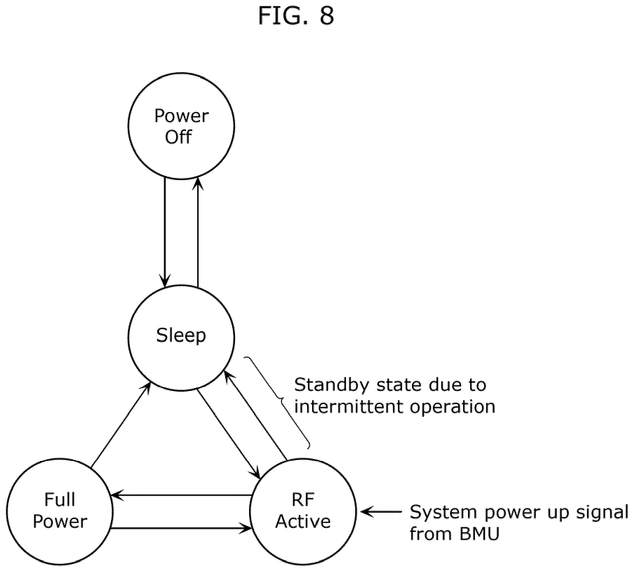

   FIG. 8 is an explanatory diagram illustrating transitions between states of a cell monitoring circuit according to Embodiment 1.
[FIG. 9]

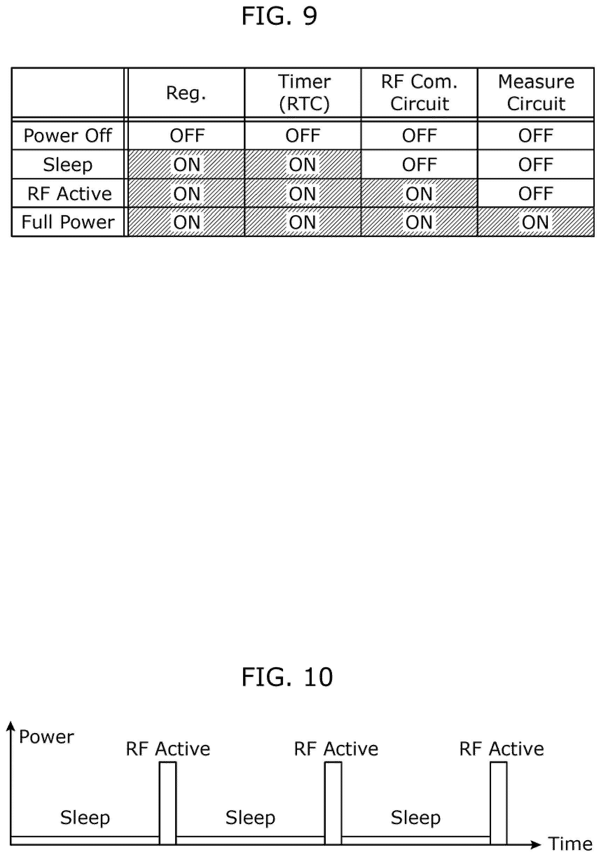

   FIG. 9 is an explanatory diagram illustrating the presence or absence of the supply of power to each circuit in the states that a cell monitoring circuit according to Embodiment 1 can be in.
[FIG. 10]
   FIG. 10 is an explanatory diagram illustrating transitions between a sleep state and an RF active state of a cell monitoring circuit according to Embodiment 1.
[FIG. 11]

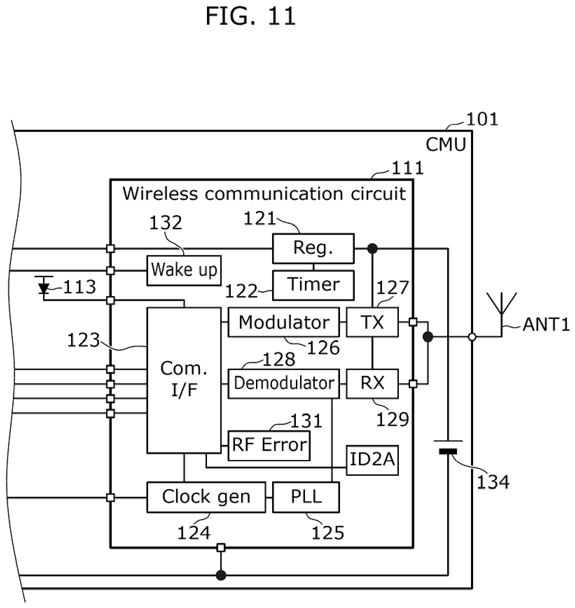

   FIG. 11 is a configuration diagram illustrating one example of a wireless communication circuit included in a cell monitoring circuit according to Variation 1 of Embodiment 1.
[FIG. 12]

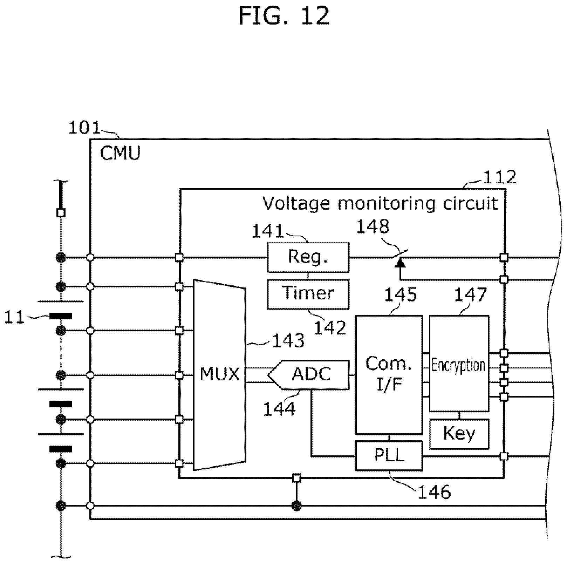

   FIG. 12 is a configuration diagram illustrating one example of a voltage monitoring circuit included in a cell monitoring circuit according to Variation 2 of Embodiment 1.
[FIG. 13]

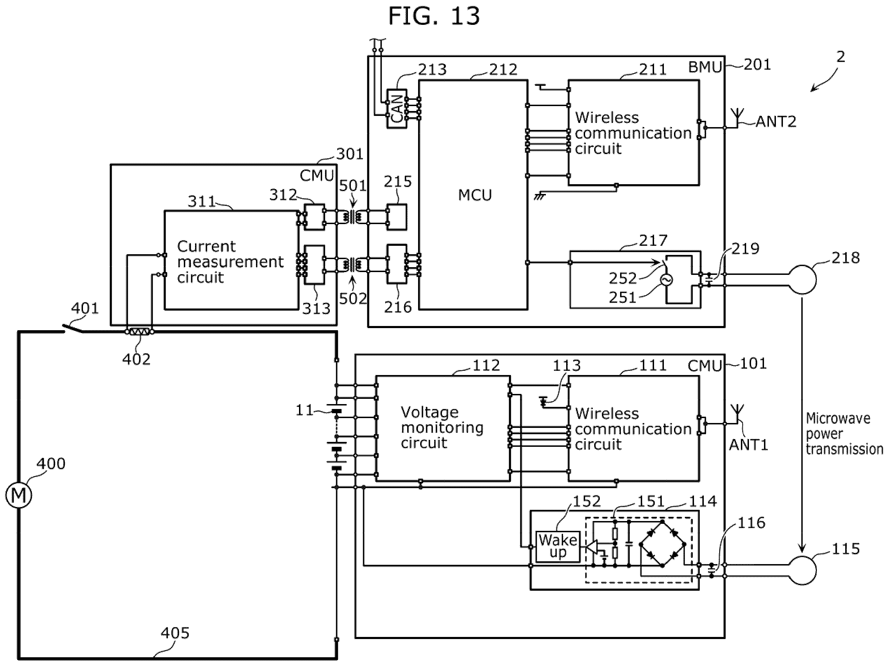

   FIG. 13 is a configuration diagram illustrating a first example of a battery management system according to Embodiment 2.
[FIG. 14]

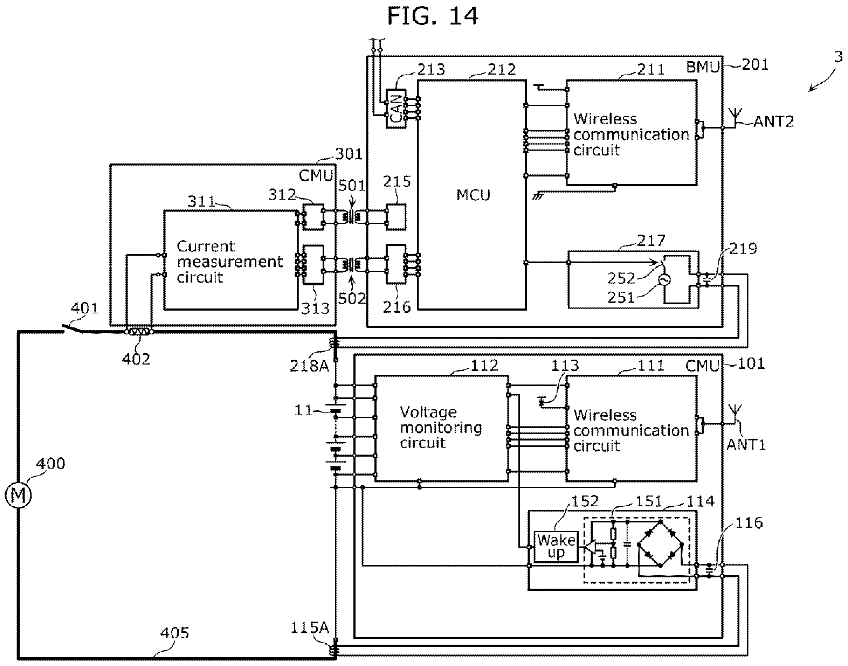

   FIG. 14 is a configuration diagram illustrating a first example of a battery management system according to Variation 1 of Embodiment 2.
[FIG. 15]

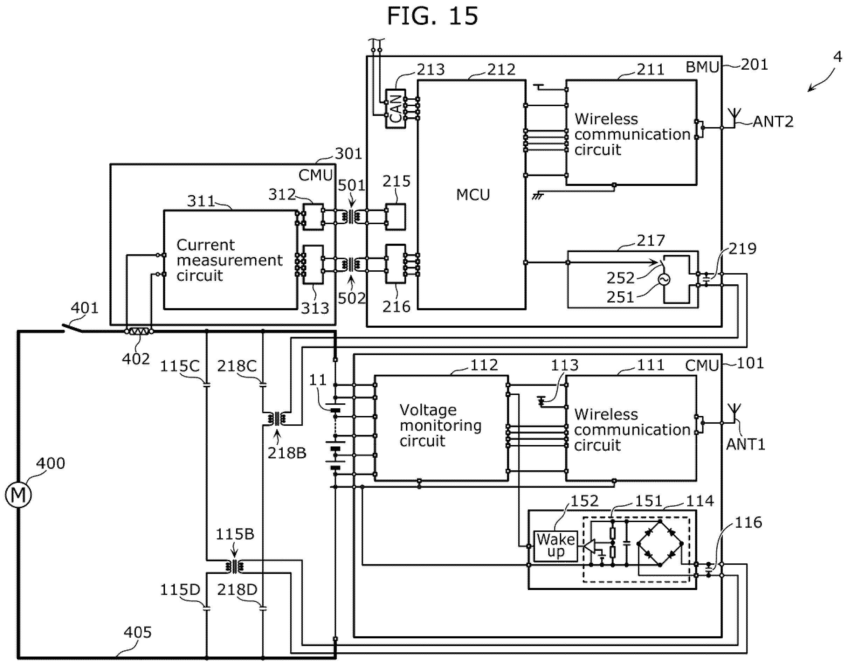

   FIG. 15 is a configuration diagram illustrating a first example of a battery management system according to Variation 2 of Embodiment 2.
[FIG. 16]

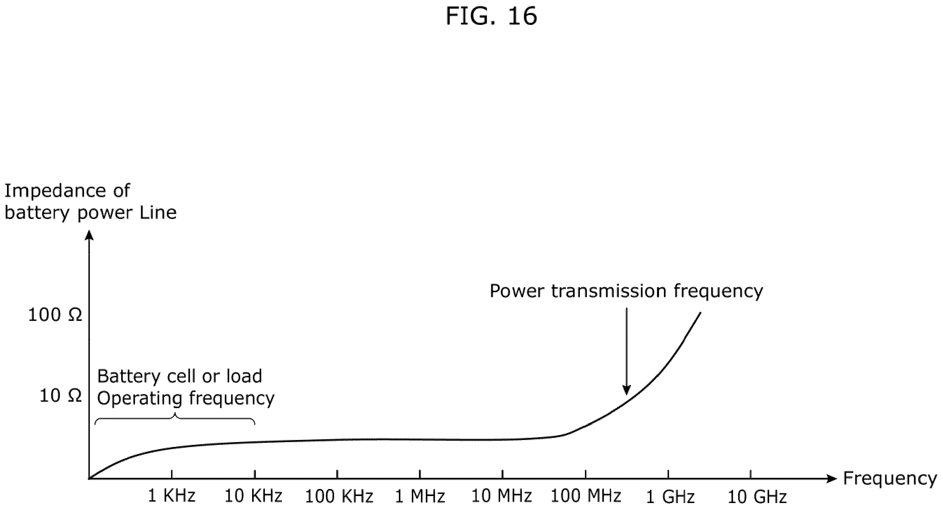

   FIG. 16 is an explanatory diagram illustrating the impedance of a power line in a battery management system according to Variation 2 of Embodiment 2.

### [Description of Embodiments]

### Underlying Knowledge Forming the Basis of the Present Disclosure

There is a battery management system that manages a battery assembly including a plurality of battery cells. The battery assembly is used, for example, as a battery for an electric vehicle.

The battery management system includes a plurality of monitoring circuits that monitor the current or voltage of the battery cells, and a management circuit that manages the battery assembly using the plurality of monitoring circuits. The monitoring circuit includes a current monitoring circuit that monitors current flowing in a battery cell, or a cell monitoring circuit that monitors voltage of a battery cell.

In the battery management system, there is a problem that a relatively large amount of power is required to operate the management circuit or the monitoring circuit.

The present disclosure has an object to overcome such a problem and provide a battery management system and the like that contributes to reducing power consumption required for processing for managing a battery assembly.

Hereinafter, one or more embodiments of the present disclosure will be described in detail with reference to the drawings.

Each embodiment described below illustrates a general or specific example. The numerical values, shapes, materials, elements, the arrangement and connection of the elements, etc., shown in the following embodiments are mere examples, and therefore do not limit the scope of the present disclosure.

### [Embodiment 1]

In the present embodiment, a battery management system that contributes to reducing power consumption required for processing for managing the battery assembly will be described.

FIG. 1 is an external view illustrating one example of battery management system (hereinafter also "BMS") 1 according to the present embodiment.

BMS 1 is a system for managing a battery assembly. For example, BMS 1 manages the state of charge (SOC), state of health (SOH), and state of power (SOP) of the battery assembly. BMS 1 monitors anomalies in the battery assembly. BMS 1 includes management circuit 200 that manages the battery assembly, and a plurality of monitoring circuits 100 that monitor the battery assembly. For example, the battery assembly includes a plurality of battery packs 10 connected in series or parallel. Battery pack 10 includes one or more battery cells. When battery pack 10 includes a plurality of battery cells, the plurality of battery cells are connected in series.

For example, monitoring circuit 100 is disposed on each of the plurality of battery packs 10. Specific examples of monitoring circuit 100, namely cell monitoring unit (CMU) 101 and current monitoring unit (CMU) 301, will be described later.

For example, management circuit 200 is connected to a battery assembly via junction box 20. Specific examples of management circuit 200, namely battery management unit (BMU) 201, will be described later.

FIG. 2 is a configuration diagram illustrating one example of BMS 1 according to the present embodiment.

FIG. 3 is a configuration diagram illustrating one example of wireless communication circuit 111 included in the first cell monitoring circuit (CMU 101). Note that FIG. 3 also illustrates elements peripheral to wireless communication circuit 111 in the configuration diagram of FIG. 2.

FIG. 4 is a configuration diagram illustrating one example of voltage monitoring circuit 112 included in the first cell monitoring circuit (CMU 101). Note that FIG. 4 also illustrates elements peripheral to voltage monitoring circuit 112 in the configuration diagram of FIG. 2.

FIG. 5 is a configuration diagram illustrating one example of current measurement circuit 311 included in the current monitoring circuit (CMU 301). Note that FIG. 5 also illustrates elements peripheral to current measurement circuit 311 in the configuration diagram of FIG. 2.

FIG. 6 is a configuration diagram illustrating one example of wireless communication circuit 211 included in the management circuit (BMU 201). Note that FIG. 6 also illustrates elements peripheral to wireless communication circuit 211 in the configuration diagram of FIG. 2.

FIG. 7 is a configuration diagram illustrating one example of MCU 212 included in the management circuit (BMU 201). Note that FIG. 7 also illustrates elements peripheral to MCU 212 in the configuration diagram of FIG. 2.

FIG. 2 focuses on one battery pack 10 among the plurality of battery packs 10. FIG. 2 illustrates a plurality of battery cells 11 included in one battery pack 10 in the battery assembly as the one or more battery cells included in the battery assembly. CMU 101 is illustrated as monitoring circuit 100, and BMU 201 is illustrated as management circuit 200. Motor 400 is illustrated as a load to which power is supplied from the battery assembly. Moreover, power line 405 (bus bar) connecting the battery assembly and motor 400, and relay 401 and shunt resistor 402 inserted in power line 405 are also illustrated.

Relay 401 is a switch for interrupting current flowing in power line 405. For example, relay 401 is turned off to interrupt current flowing in power line 405 when the current monitored by CMU 301 is determined to be anomalous. Also, for example, relay 401 is turned off to interrupt current flowing in power line 405 when the voltage monitored by CMU 101 is determined to be anomalous.

Shunt resistor 402 is a resistor for measuring current flowing in power line 405.

CMU 101 is one example of a cell monitoring circuit that monitors one or more battery cells included in the battery assembly. For example, CMU 101 monitors the voltage of each of a plurality of battery cells 11.

As illustrated in FIG. 2, CMU 101 includes wireless communication circuit 111 and communication antenna ANT1 for communicating with BMU 201. CMU 101 includes voltage monitoring circuit 112 that monitors the voltage of each of the plurality of battery cells 11. For example, wireless communication circuit 111 and voltage monitoring circuit 112 are each implemented by different integrated circuits (ICs). Note that wireless communication circuit 111 and voltage monitoring circuit 112 may be implemented by a single IC.

As illustrated in FIG. 3, wireless communication circuit 111 includes voltage conversion circuit (Reg.) 121, timer circuit (Timer) 122, communications interface (Com. I/F) 123, clock generation circuit (Clock gen) 124, phase-locked loop (PLL) 125, modulation circuit (Modulator) 126, transmission circuit (Tx) 127, demodulation circuit (Demodulator) 128, reception circuit (Rx) 129, communication error determination circuit (RF Error) 131, and wake-up circuit (Wake up) 132.

Voltage conversion circuit 121 is a circuit that converts the voltage input from voltage monitoring circuit 112 to a voltage for operating wireless communication circuit 111 and outputs the converted voltage.

Timer circuit 122 is a circuit that counts time. For example, timer circuit 122 is used to operate wireless communication circuit 111 intermittently.

Communications interface 123 is an interface for performing communication between wireless communication circuit 111 and voltage monitoring circuit 112. The identification information "ID2A" is associated with communications interface 123. Note that the identification information of communications interface 123 may be stored in any memory included in wireless communication circuit 111. Note that when wireless communication circuit 111 and voltage monitoring circuit 112 are implemented by a single IC, communications interface 123 may be omitted.

Clock generation circuit 124 is a circuit for generating a clock in CMU 101.

Phase-locked loop 125 is a circuit that adjusts the phase of a local signal to match the phase of a received signal.

Modulation circuit 126 is a circuit that modulates signals to be transmitted to BMU 201.

Transmission circuit 127 is a circuit for transmitting signals to BMU 201. Transmission circuit 127 transmits signals to BMU 201 via communication antenna ANT1.

Demodulation circuit 128 is a circuit that demodulates signals received from BMU 201.

Reception circuit 129 is a circuit for receiving signals from BMU 201. Reception circuit 129 receives signals from BMU 201 via communication antenna ANT1.

Communication error determination circuit 131 is a circuit that determines whether an anomaly has occurred in the communication between CMU 101 and BMU 201.

Wake-up circuit 132 is a circuit for activating voltage monitoring circuit 112. Wake-up circuit 132 is connected to encryption circuit 147, etc., of voltage monitoring circuit 112, and activates voltage monitoring circuit 112 by transmitting a wake-up signal.

As illustrated in FIG. 4, voltage monitoring circuit 112 includes voltage conversion circuit (Reg.) 141, timer circuit (Timer) 142, multiplexer (MUX) 143, AD converter (ADC) 144, communications interface (Com. I/F) 145, phase-locked loop (PLL) 146, encryption circuit (Encryption) 147, and switch 148.

Voltage conversion circuit 141 is a circuit that converts the voltage input from battery assembly to a voltage for operating voltage monitoring circuit 112 and wireless communication circuit 111 and outputs the converted voltage.

Timer circuit 142 is a circuit that counts time. Timer circuit 142 is connected to switch 148. Timer circuit 142 is a circuit for operating wireless communication circuit 111 intermittently. Timer circuit 142 turns on switch 148 by transmitting, upon elapse of a set amount of time (also referred to as timeout), a control signal that turns on switch 148. Timer circuit 142 turns off switch 148 by transmitting, upon elapse of a set amount of time after transmitting the control signal that turns on switch 148, a control signal that turns off switch 148.

Multiplexer 143 selects one battery cell 11 from among the plurality of battery cells 11 and outputs the terminal voltage of the selected battery cell 11. Stated differently, multiplexer 143 can output the voltage of each of the plurality of battery cells 11.

AD converter 144 converts the voltage value (analog value) of battery cell 11 selected by multiplexer 143 into a digital value.

Communications interface 145 is an interface for performing communication between wireless communication circuit 111 and voltage monitoring circuit 112. Note that when wireless communication circuit 111 and voltage monitoring circuit 112 are implemented by a single IC, communications interface 145 may be omitted.

Phase-locked loop 146 is a circuit that adjusts the phase of a local signal to match the phase of a received signal.

Encryption circuit 147 is a circuit that encrypts and decrypts signals. For example, encryption circuit 147 encrypts signals to be transmitted to wireless communication circuit 111 and ultimately to BMU 201, using an encryption key (Key).

Switch 148 is a switch that toggles on and off the power supply to wireless communication circuit 111, and is, for example, a transistor or the like. The on and off states of switch 148 may be controlled by a control signal from timer circuit 142.

CMU 101 detects the voltage value of each of the plurality of battery cells 11 using voltage monitoring circuit 112, and transmits the detected voltage values to BMU 201 using wireless communication circuit 111.

As illustrated in FIG. 2, CMU 301 includes current measurement circuit 311 that monitors current flowing in the battery assembly. CMU 301 includes power supply circuit 312 and insulated communication circuit 313.

Power supply circuit 312 is a circuit for supplying power to CMU 301, and supplies to CMU 301 power that has been supplied from BMU 201. For example, power supply circuit 312 is supplied with power from BMU 201 via transformer 501.

Insulated communication circuit 313 is a circuit for performing communication between CMU 301 and BMU 201 while maintaining insulation between CMU 301 and BMU 201. For example, insulated communication circuit 313 can perform communication between CMU 301 and BMU 201 while maintaining insulation between CMU 301 and BMU 201 by using transformer 502.

Current measurement circuit 311 is a circuit that measures current flowing in the battery assembly. More specifically, current measurement circuit 311 measures the current flowing in power line 405, that is, the current flowing in the battery assembly, by measuring the voltage generated when current flows through shunt resistor 402 provided on power line 405. As illustrated in FIG. 5, current measurement circuit 311 includes amplification circuit 321, AD converter (ADC) 322, and communications interface (Com. I/F) 323.

Amplification circuit 321 amplifies the voltage generated across shunt resistor 402. Amplification circuit 321 is provided because the resistance value of shunt resistor 402 is extremely small, and the voltage generated across shunt resistor 402 is also small.

AD converter 322 converts the voltage value (analog value) generated across shunt resistor 402 into a digital value.

Communications interface 323 is an interface for performing communication between CMU 301 and BMU 201.

As illustrated in FIG. 2, BMU 201 includes wireless communication circuit 211 and communication antenna ANT2 for communicating with CMU 101. BMU 201 also includes a micro controller unit (MCU) 212 for managing the battery assembly and a controller area network (CAN) interface 213. Note that wireless communication circuit 211 and MCU 212 may be implemented by a single IC (for example, a single MCU). BMU 201 includes power supply circuit 215 and insulated communication circuit 216.

CAN interface 213 is a communications interface that is connected to a CAN included in the vehicle equipped with the battery assembly.

Power supply circuit 215 is a circuit for supplying power to CMU 301. For example, power supply circuit 215 supplies power to CMU 301 via transformer 501.

Insulated communication circuit 216 is a circuit for performing communication between CMU 301 and BMU 201 while maintaining insulation between CMU 301 and BMU 201. For example, insulated communication circuit 216 can perform communication between CMU 301 and BMU 201 while maintaining insulation between CMU 301 and BMU 201 by using transformer 502.

CMU 301 monitors the current flowing in the high-voltage battery assembly of several hundred volts and handles high voltages, whereas BMU 201 handles voltages of only a few volts. Therefore, CMU 301 and BMU 201 are insulated by being connected via transformers 501 and 502.

As illustrated in FIG. 6, wireless communication circuit 211 includes voltage conversion circuit (Reg.) 221, timer circuit (Timer) 222, communications interface (Com. I/F) 223, clock generation circuit (Clock gen) 224, phase-locked loop (PLL) 225, modulation circuit (Modulator) 226, transmission circuit (Tx) 227, demodulation circuit (Demodulator) 228, reception circuit (Rx) 229, communication error determination circuit (RF Error) 231, and wake-up circuit (Wake up) 232. FIG. 6 illustrates "ID0A" as the identification information of wireless communication circuit 211. Note that the identification information of communications interface 223 may be stored in any memory included in wireless communication circuit 211.

Voltage conversion circuit 221 is a circuit that converts the voltage input from any power source to a voltage for operating wireless communication circuit 211 and outputs the converted voltage.

Timer circuit 222 is a circuit that counts time.

Communications interface 223 is an interface for performing communication between wireless communication circuit 211 and MCU 212. Note that when wireless communication circuit 211 and MCU 212 are implemented by a single IC, communications interface 223 may be omitted.

Clock generation circuit 224 is a circuit for generating a clock in BMU 201.

Phase-locked loop 225 is a circuit that adjusts the phase of a local signal to match the phase of a received signal.

Modulation circuit 226 is a circuit that modulates signals to be transmitted to CMU 101.

Transmission circuit 227 is a circuit for transmitting signals to CMU 101. Transmission circuit 227 transmits signals to CMU 101 via communication antenna ANT2.

Demodulation circuit 228 is a circuit that demodulates signals received from CMU 101.

Reception circuit 229 is a circuit for receiving signals from CMU 101. Reception circuit 229 receives signals from CMU 101 via communication antenna ANT2.

Communication error determination circuit 231 is a circuit that determines whether an anomaly has occurred in the communication between CMU 101 and BMU 201.

Wake-up circuit 232 is a circuit for activating MCU 212.

As illustrated in FIG. 7, MCU 212 includes encryption circuit (Encryption) 241 and identification circuit (ID identification circuit) 242. MCU 212 is connected to a CAN via CAN interface 213. A firewall is provided between MCU 212 and the CAN. MCU 212 also stores table (table of cell position and RF com. ID) 243 showing the correspondence between the positions of each of the plurality of battery cells 11 in battery pack 10 and identification information such as the wireless communication circuit of CMU 101 of each battery pack 10.

Encryption circuit 241 is a circuit that encrypts and decrypts signals. For example, encryption circuit 241 decrypts signals (for example, voltage values of battery cell 11) transmitted from CMU 101, using an encryption key (Key).

Identification circuit 242 uses table 243 to identify which position of battery cell 11 in which battery pack 10 the voltage value of battery cell 11 included in the signal transmitted from CMU 101 corresponds to.

With the above circuit configuration, BMS 1 operates as follows.

First, the plurality of states that CMU 101 can be in and how it transitions between these states will be described.

FIG. 8 is an explanatory diagram illustrating transitions between states of a cell monitoring circuit (CMU 101). FIG. 9 is an explanatory diagram illustrating the presence or absence of the supply of power to each circuit in the states that the cell monitoring circuit can be in. FIG. 10 is an explanatory diagram illustrating transitions between a sleep state and an RF active state of a cell monitoring circuit.

As illustrated in FIG. 8, the plurality of states that CMU 101 can be in include a power off state (Power Off), a sleep state (Sleep), an RF active (RF Active) state, and a full power (Full Power) state. FIG. 9 illustrates whether power is supplied (ON) or not supplied (OFF) to each of voltage conversion circuit (Reg.) 141, timer circuit (Timer (RTC)) 142, wireless communication circuit (RF Com. Circuit) 111, and voltage monitoring circuit (Measure Circuit) 112 of CMU 101 in each state. A state in which power is supplied to a circuit can also be said to be a state in which the circuit is operating, and a state in which power is not supplied to a circuit can also be said to be a state in which the circuit is not operating.

The power off state is a state in which power is not supplied to any of voltage conversion circuit 141, timer circuit 142, wireless communication circuit 111, and voltage monitoring circuit 112 (see FIG. 9). CMU 101 can transition to the sleep state when power is supplied to voltage conversion circuit 141 and timer circuit 142 in the power off state.

The sleep state is a state in which power is supplied to voltage conversion circuit 141 and timer circuit 142, and power is not supplied to wireless communication circuit 111 and voltage monitoring circuit 112 (see FIG. 9). The sleep state is a state in which power consumption is relatively low compared to the RF active state. CMU 101 can transition to the RF active state when, in the sleep state, switch 148 is controlled to turn on at a timing determined by timer circuit 142, thereby supplying power to wireless communication circuit 111. CMU 101 transitions to the power off state when power supply is cut off to voltage conversion circuit 141 and timer circuit 142 in the sleep state. The sleep state is also referred to as the second state.

The RF active state is a state in which power is supplied to voltage conversion circuit 141, timer circuit 142, and wireless communication circuit 111, and power is not supplied to voltage monitoring circuit 112 (see FIG. 9). The RF active state is a state in which power consumption is higher than in the sleep state. CMU 101 can receive a wake-up signal from BMU 201 in the RF active state, in other words, it is in standby for a wake-up signal. CMU 101 transitions to the sleep state when, in the RF active state, switch 148 is controlled to turn off at a timing determined by timer circuit 142, thereby cutting off power supply to wireless communication circuit 111. CMU 101 can perform intermittent operation in which it repeatedly transitions back to the RF active state after transitioning to the sleep state (see FIG. 10). CMU 101 transitions to the full power state when it receives a wake-up signal from BMU 201 in the RF active state. The RF active state is also referred to as the first state.

The full power state is a state in which power is supplied to every one of voltage conversion circuit 141, timer circuit 142, wireless communication circuit 111, and voltage monitoring circuit 112 (see FIG. 9). In the full power state, CMU 101 can detect the voltage values of the plurality of battery cells 11 and transmit them to BMU 201. CMU 101 can transition to the sleep state. For example, CMU 101 can transition to the sleep state when, in the full power state, a predetermined amount of time elapses without voltage monitoring by voltage monitoring circuit 112 or wireless communication by wireless communication circuit 111.

BMU 201 transmits a wake-up signal for activating CMU 101 (more specifically, a wake-up signal for activating voltage monitoring circuit 112 included in CMU 101) using communication antenna ANT2. The timing at which BMU 201 transmits the wake-up signal is, for example, the timing at which BMU 201 attempts to obtain the voltage value detected by CMU 101. When BMU 201 transmits the wake-up signal, if CMU 101 is in the RF active state, CMU 101 transitions to the full power state as a result of wireless communication circuit 111 receiving the wake-up signal and activating voltage monitoring circuit 112. However, when BMU 201 transmits the wake-up signal, if CMU 101 is in the sleep state, wireless communication circuit 111 cannot receive the wake-up signal, and CMU 101 does not transition to the full power state.

In this way, CMU 101 repeatedly transitions between the first state and the second state based on the timing at which timer circuit 142 times out.

### Variation 1 of Embodiment 1

In the present variation, in regard to a battery management system that contributes to reducing power consumption required for processing for managing the battery assembly, a configuration in which CMU 101 operates in an RF active state without using power supplied from the battery assembly will be described.

CMU 101 in the above embodiment can operate in the RF active state using power supplied from the battery assembly when switch 148 is on. However, CMU 101 in the above embodiment is in the sleep state when switch 148 is off, in other words, it cannot operate in the RF active state.

CMU 101 in the present variation can operate in the RF active state using power supplied from battery 134, without using power supplied from the battery assembly.

FIG. 11 is a configuration diagram illustrating one example of a wireless communication circuit included in a cell monitoring circuit according to a variation of the present embodiment.

CMU 101 according to the present variation includes LED 113. For example, LED 113 emits light when wireless communication circuit 111 satisfies a specific condition.

CMU 101 according to present variation includes battery 134. The power supply destination of battery 134 is wireless communication circuit 111. CMU 101 operates in the RF active state as a result of wireless communication circuit 111 operating using power supplied from battery 134. CMU 101 causes the measurement circuit (i.e., voltage monitoring circuit 112) to operate when wireless communication circuit 111 operating in the RF active state using power supplied from battery 134 receives a wake-up signal.

In this way, CMU 101 in the present variation can operate in the RF active state using power supplied from battery 134, without using power supplied from the battery assembly.

### Variation 2 of Embodiment 1

In the present variation, in regard to a battery management system that contributes to reducing power consumption required for processing for managing the battery assembly, a configuration that can reduce power consumption of the battery included in CMU 101 will be described.

The configuration of wireless communication circuit 111 included in CMU 101 according to the present variation is the same as that in Variation 1 (see FIG. 11). However, the power supply destination of the power supplied by battery 134 differs from that in Variation 1.

The power supply destinations of battery 134 included in CMU 101 according to present variation are timer circuit 122 and wake-up circuit 132. Stated differently, battery 134 does not supply power to portions of CMU 101 related to the communication function (specifically, communications interface 123, modulation circuit 126, transmission circuit 127, demodulation circuit 128, reception circuit 129, and communication error determination circuit 131) (also referred to as the communication function portion).

Timer circuit 122 is connected to wake-up circuit 132. Wake-up circuit 132 is connected to switch 148. Timer circuit 122 controls wake-up circuit 132 upon elapse of a set amount of time (also referred to as timeout) to cause wake-up circuit 132 to transmit, to switch 148, a control signal that turns switch 148 on or off.

The communication function portion of CMU 101 operates using power supplied from the battery assembly through switch 148.

FIG. 12 is a configuration diagram illustrating one example of voltage monitoring circuit 112 included in CMU 101 according to the present variation.

Switch 148 according to the present variation is a switch that toggles on and off the power supply to wireless communication circuit 111, and is, for example, a transistor or the like. Switch 148 is controlled by a control signal from wake-up circuit 132 included in wireless communication circuit 111. Timer circuit 122 and wake-up circuit 132 cause the communication function portion included in wireless communication circuit 111 to operate and thus transition to the RF active state by controlling the power supply to wireless communication circuit 111 by controlling switch 148 to turn on. CMU 101 transitions to the sleep state when switch 148 is controlled to turn off, thereby cutting off power supply to wireless communication circuit 111.

In this way, since the power supply destinations of battery 134 in CMU 101 are timer circuit 122 and wake-up circuit 132, in other words, since power is not supplied to the communication function portion, the power consumption of battery 134 can be reduced.

### [Embodiment 2]

In the present embodiment, in regard to a battery management system that contributes to reducing power consumption required for processing for managing the battery assembly, a configuration in which CMU 101 can start up without including a battery will be described.

FIG. 13 is a configuration diagram illustrating a first example of BMS 2 according to the present embodiment.

As illustrated in FIG. 13, BMS 2 includes CMU 101, BMU 201, and CMU 301, just like BMS 1 in Embodiment 1.

BMU 201 includes, in addition to the circuits included in BMU 201 of Embodiment 1, power transmission circuit 217, power transmission antenna 218, and capacitor 219.

Power transmission circuit 217 supplies alternating current (AC) power output by AC power source 251 to power transmission antenna 218. Power transmission circuit 217 includes switch 252 that switches between whether AC power is supplied to power transmission antenna 218 or not. Switch 252 may be controlled to be on or off by MCU 212.

Power transmission antenna 218 is an antenna (more specifically, a loop antenna) that transmits AC power supplied from power transmission circuit 217 as electromagnetic waves (microwaves).

Capacitor 219 removes high-frequency noise included in the AC power supplied from power transmission circuit 217 to power transmission antenna 218.

CMU 101 includes, in addition to the circuits included in CMU 101 of Embodiment 1, LED 113, power reception circuit 114, power reception antenna 115, and capacitor 116.

For example, LED 113 emits light when wireless communication circuit 111 satisfies a specific condition.

Power reception antenna 115 is an antenna (more specifically, a loop antenna) that receives electromagnetic waves (microwaves) transmitted from power transmission antenna 218 and provides AC power to power reception circuit 114.

Power reception circuit 114 converts the AC power provided from power reception antenna 115 to direct current (DC) power using conversion circuit 151, which includes a rectifier circuit and a smoothing circuit, and provides the converted DC power to wake-up circuit 152. Wake-up circuit 152 operates using the DC power provided from conversion circuit 151, and activates voltage monitoring circuit 112. Here, wake-up circuit 152 controls switch 148 to turn on by transmitting a control signal that controls switch 148 included in voltage monitoring circuit 112 to turn on, whereby voltage monitoring circuit 112 is activated by power supplied from the battery assembly.

Capacitor 116 removes high-frequency noise included in the AC power supplied from power reception antenna 115 to power reception circuit 114.

With this configuration, CMU 101 can operate by being wirelessly supplied with power from BMU 201, without including a battery. More specifically, in BMS 2, power can be supplied from BMU 201 to CMU 101 using power transmission antenna 218 and power reception antenna 115, and CMU 101 can operate using the supplied power. BMU 201 transmitting a wake-up signal using communication antenna ANT2 while supplying power to CMU 101 as described above initiates the supply of power from the battery assembly to voltage monitoring circuit 112 of CMU 101, thereby initiating the supply of power from the battery assembly to wireless communication circuit 111 and enabling CMU 101 to operate in the full power state.

### Variation 1 of Embodiment 2

In the present variation, in regard to a battery management system that contributes to reducing power consumption required for processing for managing the battery assembly, another configuration in which CMU 101 can start up without including a battery will be described.

FIG. 14 is a configuration diagram illustrating a first example of BMS 3 according to the present variation.

As illustrated in FIG. 14, BMS 3 includes CMU 101, BMU 201, and CMU 301, just like BMS 2 in Embodiment 2.

BMU 201 includes coil 218A instead of power transmission antenna 218 included in BMU 201 of Embodiment 2. Coil 218A is also referred to as a transmission coil. Coil 218A is wound around power line 405, and generates magnetic flux within power line 405 by means of AC voltage supplied from power transmission circuit 217.

CMU 101 includes, in addition to the circuits included in CMU 101 of Embodiment 1, LED 113, power reception circuit 114, coil 115A, and capacitor 116.

CMU 101 includes coil 115A instead of power reception antenna 115 included in CMU 101 of Embodiment 2. Coil 115A is also referred to as a reception coil. Coil 115A is wound around power line 405, and AC voltage is induced by the change in magnetic flux generated within power line 405 by coil 218A.

Power reception circuit 114 converts the AC power that is based on the AC voltage generated by coil 115A to DC power using conversion circuit 151, and provides the converted DC power to wake-up circuit 152. Wake-up circuit 152 operates using the DC power provided from conversion circuit 151, and activates voltage monitoring circuit 112.

With this configuration, CMU 101 can operate by being supplied with power from BMU 201 via power line 405, without including a battery. More specifically, in BMS 3, power can be supplied from BMU 201 to CMU 101 using coils 218A and 115A, and CMU 101 can operate using the supplied power. BMU 201 transmitting a wake-up signal using communication antenna ANT2 while supplying power to CMU 101 as described above initiates the supply of power from the battery assembly to voltage monitoring circuit 112 of CMU 101, thereby initiating the supply of power from the battery assembly to wireless communication circuit 111 and enabling CMU 101 to operate in the full power state.

### Variation 2 of Embodiment 2

In the present variation, in regard to a battery management system that contributes to reducing power consumption required for processing for managing the battery assembly, another configuration in which CMU 101 can start up without including a battery will be described.

FIG. 15 is a configuration diagram illustrating a first example of BMS 4 according to the present variation.

As illustrated in FIG. 15, BMS 4 includes CMU 101, BMU 201, and CMU 301, just like BMS 2 in Embodiment 2.

BMU 201 includes transformer 218B instead of power transmission antenna 218 included in BMU 201 of Embodiment 2. Transformer 218B is connected to power line 405 via capacitors 218C and 218D. Capacitors 218C and 218D inhibit DC power from flowing from transformer 218B to power line 405.

In this way, BMU 201 applies an AC voltage to power line 405 via transformer 218B.

CMU 101 includes transformer 115B instead of power reception antenna 115 included in CMU 101 of Embodiment 2. Transformer 115B is connected to power line 405 via capacitors 115C and 115D. Capacitors 115C and 115D inhibit DC power from flowing from transformer 115B to power line 405. When AC voltage is applied to power line 405 by transformer 218B, the AC voltage generated in power line 405 is applied to power reception circuit 114 via transformer 115B. Power reception circuit 114 converts the AC power that is based on AC voltage applied via transformer 115B to DC power using conversion circuit 151, and provides the converted DC power to wake-up circuit 152. Wake-up circuit 152 operates using the DC power provided from conversion circuit 151, and activates voltage monitoring circuit 112.

The frequency of the AC current flowing through power line 405 (in other words, the frequency of the AC power output by AC power source 251) will be described.

FIG. 16 is an explanatory diagram illustrating the impedance of power line 405 in BMS 4 according to the present variation. In FIG. 16, the horizontal axis shows frequency on a logarithmic scale, and the vertical axis shows the impedance of power line 405 on a logarithmic scale.

As illustrated in FIG. 16, in the frequency range greater than 0 kHz and less than or equal to approximately 10 kHz, the impedance of power line 405 is relatively small, for example, less than or equal to several ohms. For example, 2000 rpm (i.e., approximately 33 Hz) and 50,000 rpm (i.e., approximately 833 Hz) as the rotation speed of motor 400 are included in the above range.

In the frequency range from approximately 10 kHz to approximately 10 MHz, the impedance of power line 405 has a substantially constant value (for example, approximately several ohms).

In the frequency range greater than or equal to approximately 100 MHz, the impedance of power line 405 increases as the frequency increases. For example, the impedance of power line 405 is approximately several ohms at approximately 100 MHz, and exceeds 10 ohms at approximately 1 GHz.

The resonant frequency of the portions of BMU 201 related to the power transmission function (also referred to as the power transmission function portion) (for example, coil 218A and capacitor 219) can be set to the same frequency as the resonant frequency of the portions of CMU 101 related to the power reception function (also referred to as the power reception function portion) (for example, coil 115A and capacitor 116). By doing this, the power transmission function portion of BMU 201 can transmit maximum power in a resonant state, and the power reception function portion of CMU 101 can receive maximum power in a resonant state, allowing power to be transmitted from BMU 201 to CMU 101 with higher efficiency.

In power transmission using power line 405, the frequency of the AC voltage flowing through power line 405 can be set to a frequency higher than the operating frequency of the load, i.e., motor 400, connected to the battery assembly. In such cases, the resonant frequency of the power transmission function portion of BMU 201 can be set to a frequency higher than the operating frequency of the load. The resonant frequency of the power reception function portion of CMU 101 can be set to a frequency higher than the operating frequency of the load. With this, AC power can be transmitted using power line 405 while inhibiting the current flowing in power line 405.

In power transmission using power line 405, the frequency of the AC voltage flowing through power line 405 can be set to a frequency higher than, for example, 10 MHz. In such cases, the resonant frequency of the power transmission function portion of BMU 201 can be set to a frequency higher than 10 MHz. The resonant frequency of the power reception function portion of CMU 101 can be set to a frequency higher than 10 MHz. With this, AC power can be transmitted using power line 405 while inhibiting the current flowing in power line 405.

With this configuration, CMU 101 can operate by being supplied with power from BMU 201 via power line 405, without including a battery. More specifically, in BMS 4, power can be supplied from BMU 201 to CMU 101 using transformers 218B and 115B, and CMU 101 can operate using the supplied power. BMU 201 transmitting a wake-up signal using communication antenna ANT2 while supplying power to CMU 101 as described above initiates the supply of power from the battery assembly to voltage monitoring circuit 112 of CMU 101, thereby initiating the supply of power from the battery assembly to wireless communication circuit 111 and enabling CMU 101 to operate in the full power state.

Embodiments arrived at by a person skilled in the art making various modifications to the embodiment, or embodiments realized by arbitrarily combining elements and functions in the embodiments which do not depart from the essence of the present disclosure are also included in the present disclosure.

### Additional Information

The following techniques are disclosed by the description of the above embodiment.

(Technique 1) A battery management system for managing a battery assembly includes: a management circuit that manages the battery assembly; and a plurality of monitoring circuits that monitor the battery assembly. One monitoring circuit among the plurality of monitoring circuits includes: a wireless communication circuit; and a timer circuit. Based on a timing at which the timer circuit times out, the one monitoring circuit repeatedly transitions between a first state in which the wireless communication circuit is supplied with power and therefore capable of receiving a wake-up signal transmitted by the management circuit, and a second state in which the wireless communication circuit is not supplied with power.

According to the above aspect, the monitoring circuit performs intermittent operation in which it repeatedly transitions between the first state and the second state, and since power is not supplied to the wireless communication circuit in the second state, power consumption required for processing for managing the battery assembly can be reduced. Accordingly, the battery management system contributes to reducing power consumption required for processing for managing the battery assembly.

(Technique 2) The battery management system according to Technique 1, wherein the plurality of monitoring circuits include: a battery that supplies power to the wireless communication circuit; and a measurement circuit for monitoring a voltage of the battery assembly or measuring a current of the battery assembly, and the plurality of monitoring circuits cause the measurement circuit to operate when the wireless communication circuit operating in the first state using the power supplied from the battery receives the wake-up signal transmitted by the management circuit.

According to the above aspect, the monitoring circuit causes the measurement circuit to operate by receiving a wake-up signal when power is supplied to the wireless communication circuit, to monitor the voltage of the battery assembly or measure the current of the battery assembly. Accordingly, the battery management system can perform processing for managing the battery assembly while reducing power consumption.

(Technique 3) The battery management system according to Technique 1, wherein a communication function portion of the wireless communication circuit operates using the power supplied from the battery assembly, the one monitoring circuit further includes a battery that supplies power to the timer circuit, and the one monitoring circuit transitions to the first state by power being supplied from the battery assembly to the wireless communication circuit, and transitions to the second state by the supply of the power being stopped, based on a timing at which the timer circuit times out.

According to the above aspect, in the battery management system, since the power source for the wireless communication circuit of the monitoring circuit is the battery assembly rather than the battery, power consumption of the battery is inhibited. Accordingly, the battery management system contributes to further reducing power consumption required for processing for managing the battery assembly.

(Technique 4) The battery management system according to any one of Techniques 1 to 3, wherein the management circuit further includes a power transmission antenna that transmits alternating current (AC) power as electromagnetic waves, and the one monitoring circuit further includes a power reception antenna that receives the AC power transmitted as electromagnetic waves by the power transmission antenna.

According to the above aspect, since the monitoring circuit can receive power wirelessly transmitted from the management circuit, it does not need to include a battery. Accordingly, the battery management system contributes to reducing power consumption required for processing for managing the battery assembly without including a battery.

(Technique 5) The battery management system according to Technique 4, wherein the one monitoring circuit further includes a conversion circuit that converts the AC power received by the power reception antenna into direct current (DC) power, and the one monitoring circuit activates a measurement circuit using the DC power converted by the conversion circuit, the measurement circuit performing measurement for managing the battery assembly.

According to the above aspect, since the monitoring circuit can operate using DC power converted from AC power wirelessly transmitted from the management circuit, it can more easily operate without using a battery. Accordingly, the battery management system contributes to reducing power consumption required for processing for managing the battery assembly without including a battery.

(Technique 6) The battery management system according to Technique 1, wherein the management circuit further includes a transmission coil that generates a magnetic flux within a power line in the battery assembly, and the one monitoring circuit among the plurality of monitoring circuits further includes a reception coil in which alternating current (AC) voltage is induced by a change in the magnetic flux generated within the power line by the transmission coil.

According to the above aspect, since the monitoring circuit can receive AC power transmitted through a power line from the management circuit, it does not need to include a battery. Accordingly, the battery management system contributes to reducing power consumption required for processing for managing the battery assembly without including a battery.

(Technique 7) The battery management system according to Technique 6, wherein the one monitoring circuit further includes a conversion circuit that converts AC power that is based on the AC voltage generated by the reception coil into direct current (DC) power, and the one monitoring circuit activates a measurement circuit using the DC power converted by the conversion circuit, the measurement circuit performing measurement for managing the battery assembly.

According to the above aspect, since the monitoring circuit can operate using DC power converted from AC power transmitted through a power line from the management circuit, it can more easily operate without using a battery. Accordingly, the battery management system contributes to reducing power consumption required for processing for managing the battery assembly without including a battery.

(Technique 8) The battery management system according to Technique 7, wherein a resonant frequency of a power transmission function portion of the management circuit is same as a resonant frequency of a power reception function portion of the one monitoring circuit.

According to the above aspect, since the resonant frequency of the power transmission function portion and the power reception function portion is the same, the power transmission function portion can transmit maximum power in a resonant state, and the power reception function portion can receive maximum power in a resonant state. Therefore, power can be transmitted from the management circuit to the monitoring circuit with higher efficiency, in other words, the output power of the management circuit required to transmit sufficient power for operating the monitoring circuit to the monitoring circuit can be reduced. Accordingly, the battery management system contributes to further reducing power consumption required for processing for managing the battery assembly without including a battery.

(Technique 9) The battery management system according to Technique 7, wherein a resonant frequency of a power transmission function portion of the management circuit is higher than an operating frequency of a load connected to the battery assembly, and a resonant frequency of a power reception function portion of the one monitoring circuit is higher than the operating frequency of the load connected to the battery assembly.

According to the above aspect, the battery management system transmits AC power over the power line at a frequency higher than the operating frequency of the load connected to the battery assembly. Generally, the impedance characteristic of the power line with respect to frequency is such that the impedance increases as the frequency increases. Therefore, by transmitting AC power over the power line at a frequency higher than the operating frequency of the load connected to the battery assembly, AC power can be transmitted using the power line while inhibiting the current flowing in the power line. Accordingly, the battery management system contributes to further reducing power consumption required for processing for managing the battery assembly without including a battery.

(Technique 10) The battery management system according to Technique 7, wherein a resonant frequency of a power transmission function portion of the management circuit is higher than 10 MHz, and a resonant frequency of a power reception function portion of the one monitoring circuit is higher than 10 MHz.

According to the above aspect, the battery management system transmits AC power over the power line at a frequency higher than 10 MHz. Generally, the impedance characteristic of the power line with respect to frequency is such that the impedance increases as the frequency increases. Therefore, by transmitting AC power over the power line at a frequency higher than 10 MHz, AC power can be transmitted using the power line while inhibiting the current flowing in the power line. Accordingly, the battery management system contributes to further reducing power consumption required for processing for managing the battery assembly without including a battery.

(Technique 11) The battery management system according to any one of Techniques 1 to 10, wherein the plurality of monitoring circuits include a cell monitoring circuit that monitors one or more battery cells included in the battery assembly or a current monitoring circuit that measures current flowing in the battery assembly.

According to the above aspect, the battery management system contributes to reducing power consumption required for processing for managing the battery assembly including the cell monitoring circuit or the current monitoring circuit.

### [Industrial Applicability]

The present disclosure is applicable to a battery management system or the like in which wireless communication is performed within the system.

### [Reference Signs List]

1, 2, 3, 4 BMS
10 battery pack
11 battery cell
20 junction box
100 monitoring circuit
101 CMU (Cell Monitoring Unit)
111, 211 wireless communication circuit
112 voltage monitoring circuit
113 LED
114 power reception circuit
115 power reception antenna
115A, 218A coil
115B, 218B, 501, 502 transformer
115C, 115D, 116, 218C, 218D, 219 capacitor
121, 141, 221 voltage conversion circuit
122, 142, 222 timer circuit
123, 145, 223, 323 communications interface
124, 224 clock generation circuit
125, 146, 225 phase-locked loop
126, 226 modulation circuit
127, 227 transmission circuit
128, 228 demodulation circuit
129, 229 reception circuit
131, 231 communication error determination circuit
132, 152, 232 wake-up circuit
134 battery
143 multiplexer
144, 322 AD converter
147, 241 encryption circuit
148, 252 switch
151 conversion circuit
200 management circuit
201 BMU
212 MCU
213 CAN interface
215, 312 power supply circuit
216, 313 insulated communication circuit
217 power transmission circuit
218 power transmission antenna
242 identification circuit
243 table
251 AC power source
301 CMU (Current Monitoring Unit)
311 current measurement circuit
321 amplification circuit
400 motor
401 relay
402 shunt resistor
405 power line
ANT1, ANT2 communication antenna

## Claims

1. A battery management system for managing a battery assembly, the battery management system comprising:
a management circuit that manages the battery assembly; and
a plurality of monitoring circuits that monitor the battery assembly, wherein
one monitoring circuit among the plurality of monitoring circuits includes:
a wireless communication circuit; and
a timer circuit, and
based on a timing at which the timer circuit times out, the one monitoring circuit repeatedly transitions between a first state in which the wireless communication circuit is supplied with power and therefore capable of receiving a wake-up signal transmitted by the management circuit, and a second state in which the wireless communication circuit is not supplied with power.

2. The battery management system according to claim 1, wherein
the plurality of monitoring circuits include:
a battery that supplies power to the wireless communication circuit; and
a measurement circuit for monitoring a voltage of the battery assembly or measuring a current of the battery assembly, and
the plurality of monitoring circuits cause the measurement circuit to operate when the wireless communication circuit operating in the first state using the power supplied from the battery receives the wake-up signal transmitted by the management circuit.

3. The battery management system according to claim 1, wherein
a communication function portion of the wireless communication circuit operates using the power supplied from the battery assembly,
the one monitoring circuit further includes a battery that supplies power to the timer circuit, and
the one monitoring circuit transitions to the first state by power being supplied from the battery assembly to the wireless communication circuit, and transitions to the second state by the supply of the power being stopped, based on a timing at which the timer circuit times out.

4. The battery management system according to any one of claims 1 to 3, wherein
the management circuit further includes a power transmission antenna that transmits alternating current (AC) power as electromagnetic waves, and
the one monitoring circuit further includes a power reception antenna that receives the AC power transmitted as electromagnetic waves by the power transmission antenna.

5. The battery management system according to claim 4, wherein
the one monitoring circuit further includes a conversion circuit that converts the AC power received by the power reception antenna into direct current (DC) power, and
the one monitoring circuit activates a measurement circuit using the DC power converted by the conversion circuit, the measurement circuit performing measurement for managing the battery assembly.

6. The battery management system according to claim 1, wherein
the management circuit further includes a transmission coil that generates a magnetic flux within a power line in the battery assembly, and
the one monitoring circuit among the plurality of monitoring circuits further includes a reception coil in which alternating current (AC) voltage is induced by a change in the magnetic flux generated within the power line by the transmission coil.

7. The battery management system according to claim 6, wherein
the one monitoring circuit further includes a conversion circuit that converts AC power that is based on the AC voltage generated by the reception coil into direct current (DC) power, and
the one monitoring circuit activates a measurement circuit using the DC power converted by the conversion circuit, the measurement circuit performing measurement for managing the battery assembly.

8. The battery management system according to claim 7, wherein
a resonant frequency of a power transmission function portion of the management circuit is same as a resonant frequency of a power reception function portion of the one monitoring circuit.

9. The battery management system according to claim 7, wherein
a resonant frequency of a power transmission function portion of the management circuit is higher than an operating frequency of a load connected to the battery assembly, and
a resonant frequency of a power reception function portion of the one monitoring circuit is higher than the operating frequency of the load connected to the battery assembly.

10. The battery management system according to claim 7, wherein
a resonant frequency of a power transmission function portion of the management circuit is higher than 10 MHz, and
a resonant frequency of a power reception function portion of the one monitoring circuit is higher than 10 MHz.

11. The battery management system according to any one of claims 1 to 10, wherein
the plurality of monitoring circuits include a cell monitoring circuit that monitors one or more battery cells included in the battery assembly or a current monitoring circuit that measures current flowing in the battery assembly.
